Europäisches Patentamt

European Patent Office

Office européen des brevets

(19)

(11) Publication number: **0 376 709**
**A2**

## (12) EUROPEAN PATENT APPLICATION

(21) Application number: 89313630.9

(51) Int. Cl.⁵: **H01L 21/285, H01L 21/3205**

(22) Date of filing: **28.12.89**

The title of the invention has been amended (Guidelines for Examination in the EPO, A-III, 7.3).

(30) Priority: **29.12.88 JP 331157/88**

(43) Date of publication of application:
**04.07.90 Bulletin 90/27**

(84) Designated Contracting States:
**DE FR GB**

(71) Applicant: **FUJITSU LIMITED**
**1015, Kamikodanaka Nakahara-ku**
**Kawasaki-shi Kanagawa 211(JP)**

(72) Inventor: **Inoue, Minoru**
**418-1-213, Hisamoto Takatsu-ku**
**Kawasaki-shi Kanagawa, 213(JP)**
Inventor: **Watanabe, Kiyoshi**
**925-A-403, Omamedocho Kohoku-ku**
**Yokohama-shi Kanagawa, 222(JP)**
Inventor: **Hariu, Takenori**
**1221-B202, Kamikodanaka Nakahara-ku**
**Kawasaki-shi Kanagawa, 211(JP)**

(74) Representative: **Stebbing, Timothy Charles et al**
**Haseltine Lake & Co. Hazlitt House 28**
**Southampton Buildings Chancery Lane**
**London WC2A 1AT(GB)**

(54) **Method of producing a semiconductor device by metal sputtering.**

(57) A method of manufacturing a semiconductor device comprises a step of depositing a material layer (34, 36) on a stepped surface of a substrate (31, 32) by a bias-sputtering performed in an inert gas, the bias-sputtering comprises a step of heating the substrate to a temperature higher than about 350°C and at the same time applying a negative bias voltage having a magnitude larger than about 400 volts to the substrate during the sputtering.

EP 0 376 709 A2

$$R = \frac{b}{a}$$

FIG. 6

Xerox Copy Centre

## METHOD OF FABRICATING A SEMICONDUCTOR DEVICE

BACKGROUND OF THE INVENTION

The present invention generally relates to fabrication of semiconductor devices and more particularly to a method of providing a planarized, long-lifetime metallizations and interconnections on a stepped surface of a material layer constituting a semiconductor device.

Currently, various materials are used for interconnecting and metallizing devices in semiconductor integrated circuits. These materials include pure aluminium, aluminium alloy of various compositions, refractory metals such as titanium (Ti), tungsten (W), molybdenum (Mo), copper (Cu) and the like, alloy or mixture of these refractory metals, compounds of refractory metals combined with other elements such as silicides of Mo or W, and the like. These materials are usually deposited on a material layer or a substrate constituting the semiconductor device by sputtering.

With increasing degree of miniaturization of semiconductor devices, the substrate or material layer on which a conductor layer of the foregoing materials is to be provided for interconnection or metallization, tends to have a surface defined with minute steps. For example, the aspect ratio of a through hole provided for interconnection between a conductor layer on a top side of the substrate and another conductor layer below the substrate is increased with decreasing hole dimension. Note that the aspect ratio is defined as a step height of the hole divided by the hole diameter. Responsive thereto, there is a difficulty in forming the conductor layer by sputtering such that the conductor layer fills the through hole or covers the steps with excellent step coverage. Particularly, the poor step coverage becomes an acute problem when a multi-level interconnection or metallization structure is to be constructed. In the multi-level interconnection or metallization, it is essential that the conductor layer has a planarized top surface irrespective of whether the conductor layer covers a flat part or stepped part of the substrate such as the through hole.

In order to solve the foregoing problem of poor step coverage and planarization, a so-called bias sputtering technique is proposed recently in which deposition of the conductor layer is made while applying a negative bias voltage to the substrate. According to this technique, atoms of sputtered conductor material maintain a sufficient thermal and kinetic energy even after arrival at the surface and move along the surface of the substrate relatively freely. Further, a sputter-etching of the conductor layer is performed simultaneously to the deposition. Thus, any depression in the sputtered conductor layer is filled by the atoms of the conductor material moving laterally along its surface and any sharp projections on the surface which may become a nuclei of rough surface is constantly flattened as a result of the sputter-etching. Thereby, a planarized surface is guaranteed for the sputtered conductor layer. In other words, the conductor layer is deposited on the stepped part of the substrate with an improved step coverage. When depositing Al or Al alloy (such as Al-1%Si, Al-1%Si-0.5%Cu, Al-2.0%Cu, and the like) as the conductor layer, the negative bias voltage applied to the substrate is in the order of -400 - -600 volts. Further, it is known that a further improved step coverage is obtained by maintaining the substrate at a temperature of 200 - 300 °C.

In the bias-sputtering technique proposed heretofore, however, there is a problem in that positively charged argon (Ar) ions in the plasma are accelerated by the negative bias voltage of the substrate and impinge into the sputtered conductive layer itself, thereby causing not only the foregoing desirable sputter-etching effect but also an undesirable deterioration in the property of the sputtered conductor layer. Particularly, the Ar atoms incorporated into the sputtered conductor layer act as defects and cause a degradation of resistance against electromigration when the conductor is used for interconnection or metallization. Such a degradation of the conductor layer reduces the mean-time-to-failure (MTF) and causes a problem of reliability of the semiconductor device. Further, when a large amount of Ar is incorporated into the conductor layer, the grain growth in the conductor layer is suppressed and the resistivity of the conductor layer is increased because of the excessive scattering of electrons at the grain boundary. As will be easily understood, excessive negative bias voltage, exceeding about -300 volts for example, causes excessive Ar incorporation into the deposited conductor layer and is therefore not desirable. According to the experiments conducted by the applicants for depositing Al or Al alloy under a bias voltage set at about -300 volts, the Ar-content in the deposited conductor layer could not be reduced satisfactorily even when the temperature of the substrate is raised to more than about 400 °C.

On the other hand, there is no report of bias sputtering conducted in a region of the bias voltage exceeding about -400 volts and at the same time in a region of the substrate temperature exceeding about 400 °C, probably because of the prediction from the foregoing tendency that no significant improvement would be achieved in such a region. It would be natural to predict that the Ar-content in the deposited layer would increase further even when the substrate temperature is increased beyond about 400 °C if a larger negative bias voltage is applied, judging from the foregoing observations. The applicants made experiments of bias sputtering under various conditions including the foregoing region and made a discovery that the Ar-content in the deposited conductor layer decreases significantly and suddenly, contrary to the prediction, when the condition of sputtering has entered into the foregoing region where the substrate temperature exceeds about $400°C$ and the negative bias voltage exceeds about -400 volts in the negative direction (Hariu, T., Watanabe, K., Inoue, M., Takada, T., Tsuchikawa, H., IEEE/IRPS, April 1989, published later than the priority date claimed in the present application), which discovery constitutes the basis of the present invention.

## SUMMARY OF THE INVENTION

Accordingly, it is a general object of the present invention to provide a novel and useful method of depositing a conductor layer by a bias-sputtering technique wherein the aforementioned problems are eliminated.

Another and more specific object of the present invention is to provide a method of depositing a conductor layer on a stepped surface by a bias-sputtering technique with an excellent step coverage.

Another object of the present invention is to provide a method of depositing a conductor layer on a stepped surface of a substrate by a bias-sputtering technique for interconnecting or metallizing semiconductor devices, wherein the reliability of interconnection and metallization is improved.

Another object of the present invention is to provide a method of depositing a conductor layer on a stepped surface by a bias-sputtering technique with an excellent planarization of a top surface of the deposited conductor layer.

Another object of the present invention is to provide a method of depositing a conductor layer on a stepped surface of a substrate by sputtering undertaken in an inert atmosphere with a negative bias voltage applied to the substrate, wherein the substrate is held at a temperature higher than a critical temperature above which the content of Ar is reduced substantially below about 1 atomic percent (atm%), or above which a ratio of step coverage, defined as a minimum thickness of the conductor layer divided by a layer thickness of the conductor layer on a flat part of the substrate, is increased stepwise, and the sputtering is performed under a negative bias voltage with a magnitude set larger than that of a critical bias voltage above which the ratio of step coverage increases stepwise. According to the present invention, the step coverage is improved significantly to a near-ideal extent. Further, the defects in the conductor layer caused by the impinged Ar is reduced significantly. Associated therewith, the reliability of interconnection or metallization structure is improved and the planarization of the structure is achieved simultaneously.

Other objects and further features of the present invention will become apparent from the following detailed description when read in conjunction with attached drawings.

## BRIEF DESCRIPTION OF THE DRAWINGS

FIG.1 is a diagram showing a sputtering apparatus used in the present invention for depositing a conductor layer on a substrate by the bias-sputtering technique;

FIG.2 is a graph showing a relation between the content of Ar in the deposited conductor layer as a function of a bias voltage;

FIGS.3(A) and (B) are graphs showing a relation between the content of Ar in the deposited conductor layer as a function of temperature of the substrate under a bias voltage of -600 volts applied to the substrate;

FIG.4 is a graph showing a correlation between the content of Ar and the mean grain size in the deposited conductor layer;

FIG.5 is a graph showing a relation between the MTF and the median grain size;

FIG.6 is a cross sectional view showing a step coverage by the conductor layer according to a first embodiment of the present invention;

FIG.7 is a cross sectional view showing the step coverage according to a prior art method for the purpose of comparison;

FIGS.8(A) and (B) are graphs showing a rate of step coverage as a function of the temperature and the bias voltage respectively in correspondence to FIG.6 and FIG.7;

FIG.9 is a diagram graphically showing a boundary of a region in which a satisfactory sputtering is obtainable;

3

FIG.10 is a cross sectional view showing the step coverage by another conductor layer according to a second embodiment; and

FIG.11 is a cross sectional view showing the step coverage by the conductor layer of FIG.9 according to a prior art method for the purpose of comparison.

DETAILED DESCRIPTION

First, the experiments conducted by the applicants will be described.

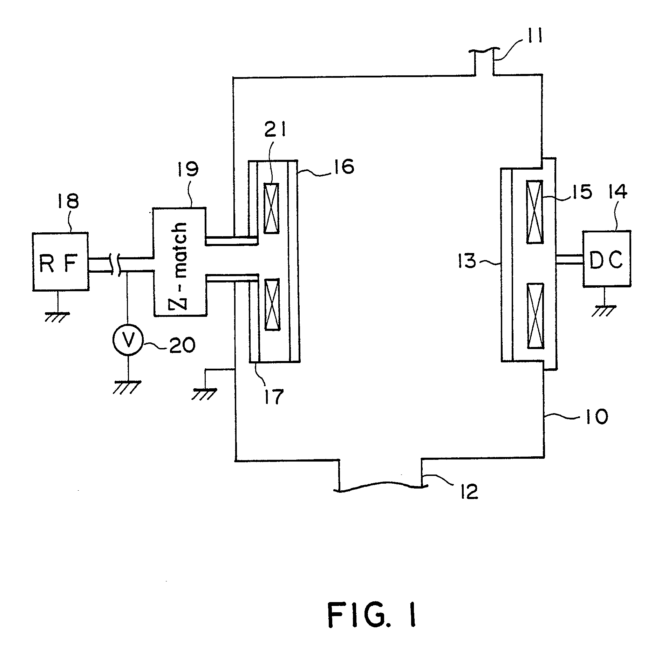

FIG.1 shows the apparatus used for the bias sputtering experiment. Referring to the drawing, the apparatus comprises a sputtering chamber 10 having an inlet 11 for introducing Ar gas and an outlet for evacuating the sputtering chamber 10. In the chamber 10, there is provided an 8-inch diameter target 13 of Al or other material to be sputtered and the target 13 is applied with a d.c. bias voltage by a DC power source 14. Behind the target 13, there is provided a magnet 15 as usual in the magnetron sputtering apparatus for concentrating the plasma to the target 13.

Facing the target 13, a substrate 16 is held on a substrate holder 17 which in turn is provided on a side of the chamber 10 opposing the side on which the target 13 is provided, and the substrate 16 is applied with a radio frequency (r.f.) energization from an RF power source 18 via an impedance matching circuit 19 as well as via the substrate holder 17. The radio frequency energization generated by the RF source 18 has a frequency of statutory prescribed 13.56 MHz and induces a selective accumulation of electrons in the substrate 16, thereby applying a negative d.c. bias voltage to the substrate 16. The negative d.c. bias voltage is controlled by changing the power of the r.f. energization while measuring the bias voltage directly by a voltage meter 20.

Note that the construction of the substrate 16 is identical to that of the target of a typical r.f. sputtering apparatus. Thus, collision of the positively charged Ar ions to the substrate 16 causes a sputtering evaporation or sputter-etching of the substrate, and the deposition of the material on the substrate 16 from the target 16 proceeds simultaneously to the etching of the substrate 16. Thereby, sharp projections on the material layer deposited on the surface of the substrate 16 is selectively etched and a flat, smooth surface is obtained.

Further, the holder 17 is provided with a heater 21 for controlling the temperature of the substrate 16. In order to improve the efficiency of heating of the substrate 16, the holder 17 is constructed to have a hollow structure, and the heater 21 is used to heat the argon gas in the hollow structure which transports the heat to the substrate efficiently. Thus, the Ar gas is used in this case as a heating medium. Further, it may be possible to heat the substrate 16 by directly flowing the current to the holder 17.

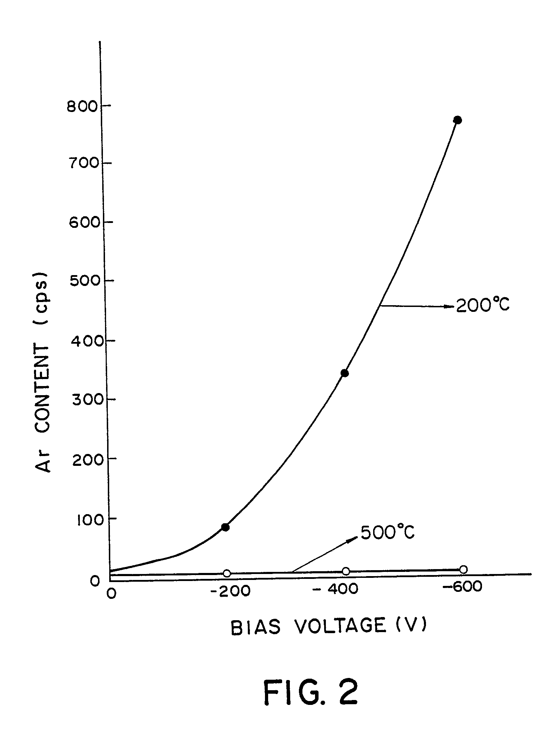

FIG.2 shows a result of experiments conducted for an Al alloy having a composition of Al-2.0%Cu while changing the negative bias voltage from -200 volts to -600 volts. As already noted, the bias voltage is controlled by changing the output r.f. power of the RF source 18 while monitoring the voltage meter 20. The substrate 16 used for the experiment was an (100) oriented silicon wafer with a phosphosilicate glass (PSG) layer having a thickness of 1.0 μm which in turn is covered by a titanium (Ti) layer with a thickness of 200 Å. This Ti layer is provided so as to avoid formation of droplet of sputtered material which tends to appear when metals such as Al or the Al alloy are sputtered directly on the surface of PSG or silicon oxide. Note that such a droplet is formed as a result of the surface tension of the Al alloy or other metals provided on the surface of the PSG layer. These sputtered metals have an increased fluidity when the temperature of sputtering is high and close to the melting point of the sputtered material. By providing a refractory metal layer such as the Ti layer having the high melting point on the PSG layer, the wettability of the sputtered metal layer is improved. Another reason of providing the Ti layer is to reduce the thermal radiation from the deposited layer and to obtain a higher surface temperature of the substrate. As a result, the particles arrived at the surface of the substrate retain a sufficient energy and move freely. Further, the material for covering the PSG layer is not limited to Ti but other refractory materials such as W, titanium tungstenide (TiW), Mo, tantalum (Ta), niobium (Nb), and the like may be used provided that the refractory material has a melting point higher than that of the material to be deposited thereon. The thickness of the foregoing refractory materials is not limited to 200 Å but may be several hundred angstroms.

In a first series of experiments represented by solid circles in the drawing, the substrate 16 was held at a temperature of 200°C and the sputtering was performed for 35 seconds with a d.c. sputtering power of 13 kW under a flow rate of Ar set at 80 sccm while increasing the bias voltage from zero volt in the negative direction. In a second series of experiments represented by open circles, on the other hand, the temperature of the substrate 16 was set at 500°C and the sputtering was repeated under a same condition except for the temperature.

As shown in FIG.2, the content of Ar in the sputter deposited Al alloy layer, measured by the X-ray

4

fluorescent (XRF) analysis, is increased in the first series experiments at 200°C with the increasing bias voltage. Note that the content of Ar in FIG.2 is represented as the number of counts (c.p.s.) of the Kα radiation emitted by the Ar atoms in the alloy layer in a unit time upon excitation by a characteristic X-ray radiation from a chromium (Cr) target.

When the temperature of the substrate 16 is set at 500°C, on the other hand, the expected tendency that the Ar content increases with increasing bias voltage is totally disappeared as is clearly seen in FIG. 2 and the Ar-content remains constant at a level of no bias voltage even when a bias voltage of up to -600 volts or more is applied. This change of the tendency between the first and second series of experiments at 200°C and 500°C is so complete and distinct that it leads to an inferrence that they represent different phenomena taking place in respective temperature regions separated by a critical temperature.

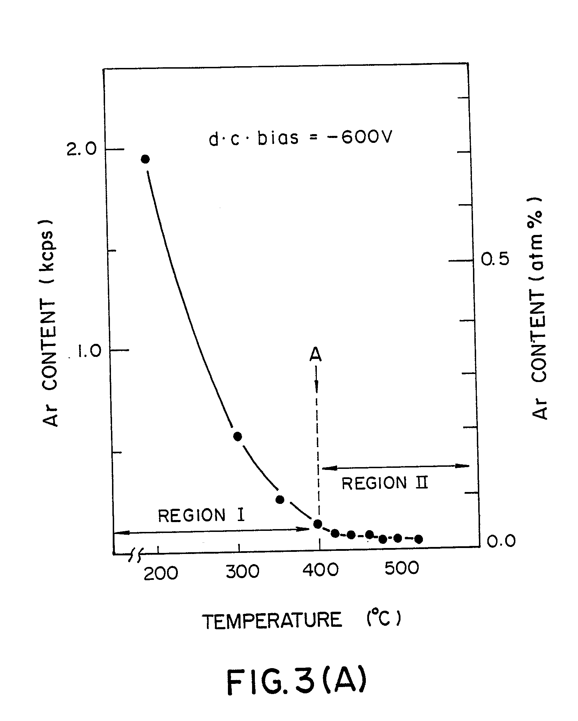

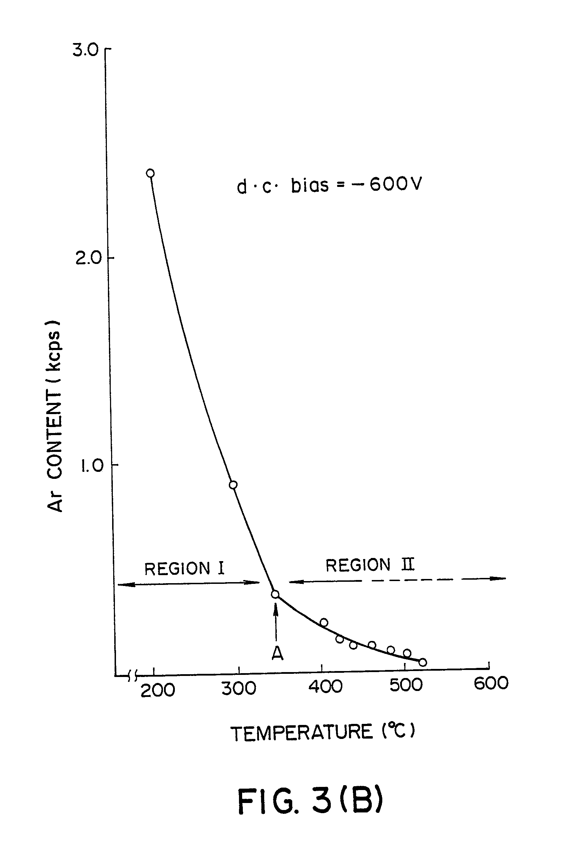

Accordingly, the applicants conducted a detailed research of bias sputtering using the same Al-2.0%Cu alloy under a d.c. bias voltage of -600 volts at various intermediate temperatures. FIG.3(A) shows the result of this research. Similarly to FIG.2, the content of Ar is represented by the number of counts of the fluorescent Kα X-ray radiation emitted from Ar. Note that the absolute scale for the count does not coincide each other in FIG.2 and in FIG.3(A) because of the difference in the condition at the time of measurement. For the data point corresponding to the substrate temperature of 200°C and the d.c. bias voltage of -600 volts, the content of Ar was directly measured by the Rutherford backscattering spectroscopy (RBS) and a value of 0.7 atm% was obtained. On the basis of this measurement, the number of counts of the X-ray fluorescent radiation in FIG.3(A) was converted to the Ar-content as shown in the ordinate at the right hand side, on the assumption that the intensity of the X-ray fluorescent radiation is proportional to the concentration of the element to be measured in such a region of low concentration level.

From FIG.3(A), it will be seen that the Ar-content in the deposited Al alloy layer is decreased with increasing substrate temperature with a gradient or temperature coefficient which changes suddenly at a temperature shown by an arrow A which is about 400°C. Below 400°C, the curve has a slope of more than about -0.1 atm%/100°C while above 400°C, the curve has a slope of less than about -0.025 atm%/100°C. Thus, the slope of the Ar-content versus temperature curve of FIG.3(A) is changed by a factor of more than 2, probably more than 4, across the critical temperature A at 400°C. In other words, the temperature region in FIG.3(A) is divided by the critical temperature A into a first region I where the gradient is steep and a second region II where the gradient is gentle. Note that the region II is not only characterized by the gentle slope of the curve but also by the Ar-content which is substantially smaller than 1 atm%, probably less than 0.5 atm%.

FIG.3(B) shows a graph similar to FIG.3(A) for another series of experiments undertaken at the bias voltage set at -600 volts. In this series of experiments, too, it can be seen clearly that the temperature region is divided into the region I and the region II, though the critical temperature separating the region II from the region I is shifted slightly lower to a temperature of about 350°C. Thus, the foregoing values of the critical temperature itself may not be the absolute measure of the division of the region I and the region II as such a value may be changed depending on the sputtering condition. Nevertheless, it is demonstrated, also in this graph, that there exists a critical temperature at which the property of the deposited layer is changed suddenly suggesting that the phenomenon taking place during the sputtering is different in the region I and in the region II, although the exact nature of the phenomenon behind the foregoing observations is not understood at the moment.

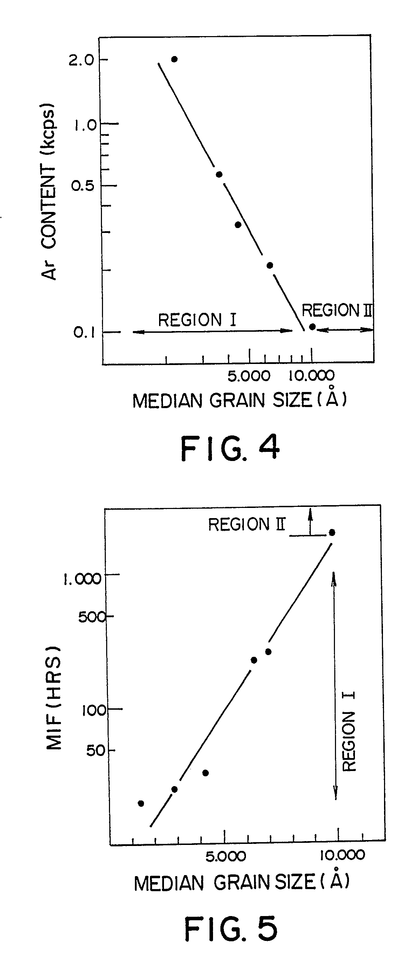

FIG.4 shows a relation between the Ar content represented by the number of counts of XRF radiation and a median grain size. Note that the grain size measurement was performed by the TEM observation of the grains in the sputtered layer and each dot in FIG.4 corresponds to the experimental point in FIG.3(A), though not all of the experimental points are represented in FIG.4 because of the clarity of the drawing. From FIG.4, it is clear that there is a distinct correlation between the Ar content and the median grain size. In the region II where the Ar-content measured by the number of counts of the XRF radiation is characteristically smaller than about 0.1 kcps, the mean grain size becomes equal to or larger than about 10,000 Å while in the region I, the median grain size becomes substantially smaller than 10,000 Å.

Further, FIG.5 shows a relation observed between the median grain size and the MTF. The samples used for this experiment had a width of 2.0 μm, a length of 800 μm, and a thickness of 1 μm. As is clear from the drawing, there is a distinct correlation also between the MTF value and the median grain size, which means that there is a correlation between the Ar-content and the MTF value. The MTF was measured by flowing a d.c. current with a current density of $2.0 \times 10^6$ A/cm$^2$ at a temperature of 200°C. The time-to-failure herein is defined as a time at which the resistivity of the sputtered conductor layer is doubled with respect to the initial resistivity value, and the MTF value was determined by applying the Weibull distribution to the obtained time-to-failure data.

Combining FIGS.3(A), 4 and 5, it can be seen that the MTF in the region II where the median grain size

5

is larger than about 10,000 Å exceeds 1,000 hours while in the region I, the MTF is substantially smaller than 1,000 hours.

The following TABLE I rearranges the data of MTF in FIG.5 into a combination of the bias voltage and the substrate temperature at the time of sputtering. As will be apparent from the TABLE I, the MTF decreases significantly with the bias voltage when the temperature of the substrate is held at 200°C while it does not change significantly with the bias voltage when the temperature is held at 500°C, in agreement with the relation shown in FIG.2. Note that MTF is correlated to the Ar-content as already described.

TABLE I

| Result of MTF Measurement | | |
|---|---|---|
| | substrate temperature (°C) | |
| BIAS VOLTAGE (V) | 200 | 500 |
| 0 | 360 hr | 1300 hr |
| - 200 | 50 hr | - |
| - 400 | 30 hr | 990 hr |
| - 600 | 50 hr | 1080 hr |

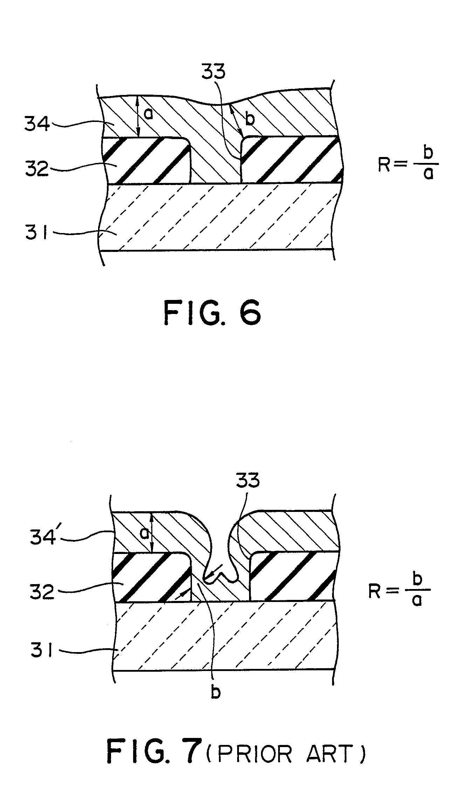

Next, another series of experiments which leads straight to a first embodiment of the present invention will be described with reference to FIGS.6 and 7. In this series of experiments, the foregoing Al alloy having a composition of Al-2.0%Cu was deposited in a form of a layer 34 or 34′ on a substrate 31 of silicon covered with a PSG layer 32 of 1μm thickness which now has a through hole 33 or 1 μm diameter, and an observation was made for the step coverage at the through hole by the Al alloy. The sputtering was made using the apparatus of FIG.1 while changing the substrate temperature and the bias voltage similarly to the foregoing case. The observation of the step coverage was made by cleaving the specimen across the through hole 33 and examining the cross section of the through hole 33 by scanning electron microscopy.

In the description hereinafter, a rate of step coverage R will be defined as a thickness a of the sputtered layer 34 or 34′ on a flat surface part divided by a minimum thickness b of the layer at a stepped part of the through hole 33, or R = b/a as shown in FIGS.6 and 7, in which FIG.6 shows a case where there is an excellent step coverage and FIG.7 shows a case where there is only a poor step coverage. Naturally, the parameter R in FIG.6 is much larger than the parameter R in FIG.7.

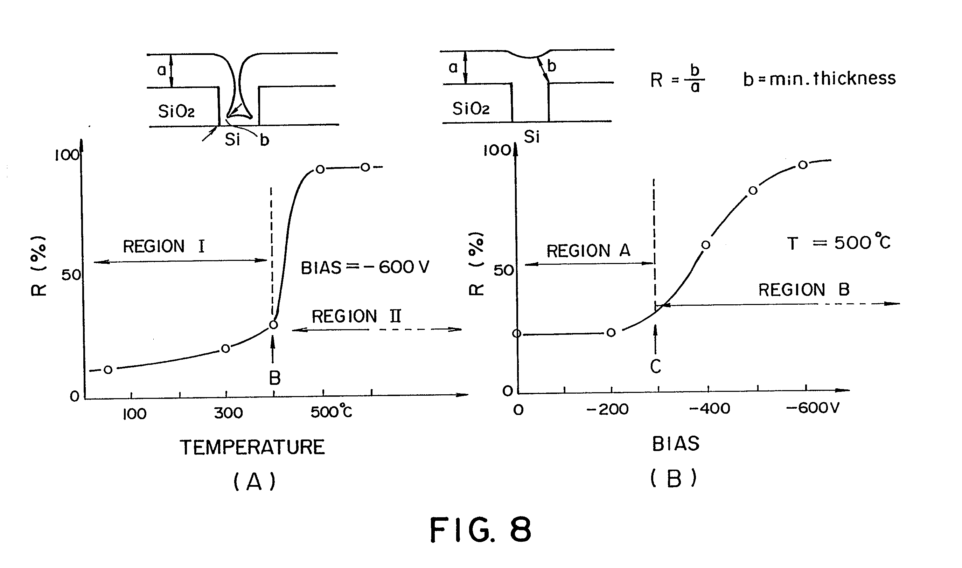

FIGS.8(A) and (B) show the result of measurement for the parameter R in the sputtered alloy layer of Al-2.0%Cu covering the foregoing through hole 33 while changing the condition of sputtering similarly to the foregoing cases shown in FIGS.2 and 3(A). Thus, in a series of experiments, the temperature of the substrate 31 was changed from room temperature to 600°C while maintaining the bias voltage at -600 volts as shown in FIG.8(A), and the bias voltage was changed from zero volt to -600 volts while maintaining the temperature of the substrate 31 at 500°C as shown in FIG.8(B).

From FIG.8(A), it is clear that the rate of step coverage R is increased suddenly and stepwise at a temperature of about 400°C as indicated by an arrow B in FIG.8(A). In other words, it is apparent that different phenomena are taking place during the sputtering in a temperature region I′ below the temperature B and in a temperature region II′ above the temperature B, thereby the temperature B acting as a critical temperature separating the region I′ and the region II′. As the critical temperature B substantially coincides with the critical temperature A defined in FIGS.3(A) and (B), it is almost certain that the phenomena taking place in the region I and in the region I′ are corresponding each other and that the phenomena taking place in the region II and in the region II′ are corresponding each other. More specifically, it is inferred that the stepwise increase of the step coverage at the critical temperature B in FIG.8(A) is related to the change of the rate of decrease of the Ar-content at the critical temperature A in FIG.3(A) and that the critical temperature A and the critical temperature B represent a same boundary. In the region I′, note that the rate of step coverage R is below about 30 % while in the region II′, the parameter R is above 90 %. Thus, the parameter R jumps about three times across the critical temperature B. Further, the rate of change of the parameter R in a 100°C temperature interval or the slope of the curve of FIG.8(A) increases from about 10%/100°C to about 70%/100°C at the temperature B. This increase of the slope is about seven times.

6

FIG.8(B) shows that there is also a stepwise increase in the rate of step coverage R with the bias voltage across a critical voltage indicated by an arrow ˚C. This voltage C is located somewhere between -300 --400 volts, probably close to -300 volts and the parameter R jumps from a first value of about 25 % in a region A below the voltage C to a second value of about 60 % or more in a region B above the voltage C with a factor of more than 2. When the bias voltage is increased to about -500 - -600 volts, the parameter R reaches a level of 90 % or more.

From the foregoing description, it will be understood that a reliable, low Ar-content, near-ideally planarized interconnection or metallization layer shown in FIG.6 or FIG.8(B), which constitutes the first embodiment of the present invention, is obtained by sputtering the conductor material under a negative bias voltage and a substrate temperature set so as to fall in the region II for the temperature and in the region B for the bias voltage. As already described, the region II is characterized by the Ar-content substantially lower than about 1%, the median grain size of larger than about 10,000 Å, and the rate of step coverage R of at least larger than 50 %, while the region B is characterized by the rate of step coverage R larger than 50 %.

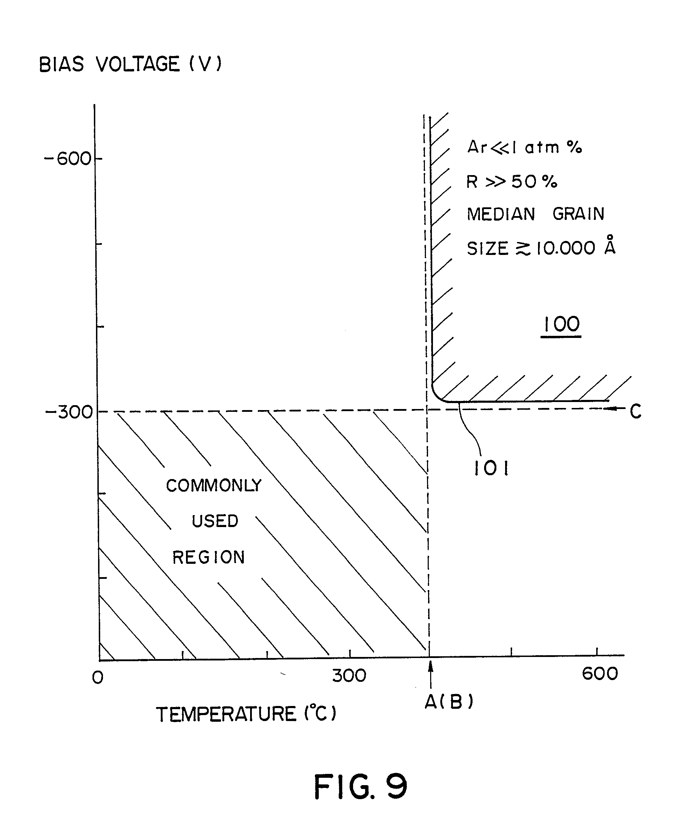

FIG.9 summarizes graphically the relation described heretofore. Referring to the drawing, there is a region 100 in the upper-right part of the field, bounded by a boundary 101 at which the property such as the Ar-content, rate of step coverage R, median grain size etc. change stepwise in correspondence to the critical temperature A ( = B) and the critical voltage C as illustrated, and in this region, the Ar-content is substantially smaller than 1 atm%, the rate of step coverage R substantially larger than 50 %, and the median grain size larger than 10,000 Å. Thus, the boundary 101 is by no means an arbitrarily drawn hypothetical boundary across which the property changes without remarkable event but does reflect a qualitative and quantitative change of the phenomenon taking place during the sputtering. By performing the sputtering under the combination of the temperature and the bias voltage falling in the region defined by the boundary 101, the structure as shown in FIG.6 containing little defects and having an extended lifetime is obtained.

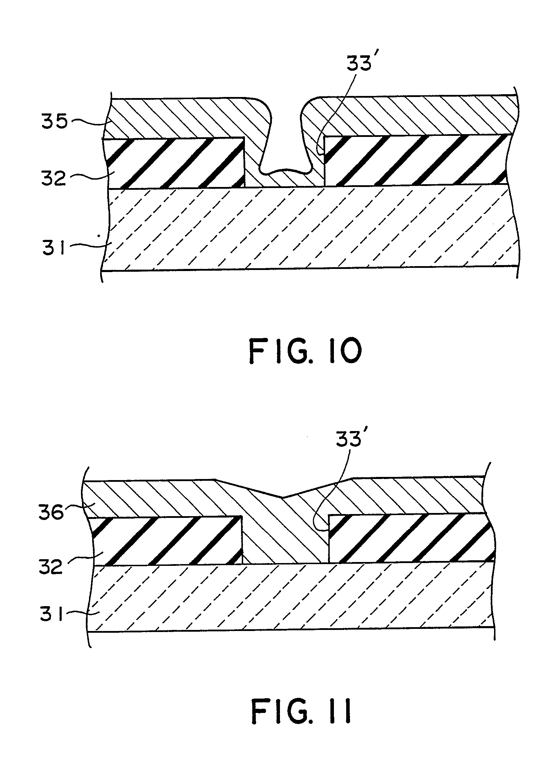

Next, a second embodiment of the present invention will be described with reference to FIGS.10 and 11. In the drawings, these parts already described with reference to the preceding drawings are given identical reference numerals and the description thereof will be omitted.

In this embodiment, W is used as the target 13 in the apparatus of FIG.1 and a layer of W is deposited for a thickness of about 0.5 μm, for example, on a PSG layer 32 including a through hole 33, which now has a diameter of 1.6 μm. In a typical example, the temperature of the substrate 31 is held at 450˚ C and a negative bias voltage of -1000 volts is applied to the substrate 31 during the sputtering. The r.f. power generated by the RF source 18 in correspondence to this voltage may be set to 200 W. The DC source 14 for establishing the plasma is driven with a power of 7 kW and the Ar gas is supplied to the chamber 10 with a flow rate of 40 sccm. Under this condition, the conductor layer 36 shown in FIG.11 having an excellent step coverage is obtained.

In order to examine the effect of the negative bias voltage applied simultaneously to the substrate temperature of above 400˚ C, a reference experiment was conducted in which a layer 35 of W is sputtered on the PSG layer 32 including the through hole 33′ under a same condition except for the bias voltage which is set to zero volt. The result of this experiment is shown in FIG.10. Obviously, the layer 35 has a poor step coverage and thus, the effect of the negative bias voltage applied simultaneously to the temperature is clearly demonstrated. Improvement of reliability of the tungsten wiring due to the decreased content of Ar is recognized even at a substrate temperature of about 500 ˚ C.

When depositing alloy, mixture, or compound of refractory metals such as Ti, W, Mo, or Cu with a planarized top surface, the magnitude of the negative bias voltage applied to the substrate is preferrably larger than about 1000 volts in correspondence to the large energy needed for moving the atoms as compared to the case of Al or Al alloys. However, the magnitude is preferable to be smaller than about 2000 volts in order to avoid excessive etching effect which reduces the growth rate of the deposited film.

The thickness or number of layers deposited by the present invention is of course not limited to those described heretofore. Thus, the present invention is useful in multi-layered interconnection and metallization structure. Further, the inert gas used in the sputtering is not limited to Ar but other inert gases such as neon may also be used. Further, the method of the present invention is not only useful in the interconnection and metallization structures but may also be used for providing gate electrode or buried electrode in the three-dimensional devices.

Further, the present invention is not limited to these embodiments described heretofore, but various variations and modifications may be made without departing from the scope of the invention.

**Claims**

1. A method of manufacturing a semiconductor device comprising a step of depositing a material layer (34, 36) on a stepped surface of a substrate (31, 32) by a bias-sputtering performed in an inert gas, characterized in that said bias-sputtering comprising a step of heating the substrate to a temperature higher than about 350° C and at the same time applying a negative bias voltage having a magnitude larger than about 400 volts to the substrate during the sputtering.

2. A method as claimed in claim 1 characterized in that said method further comprises a step of providing a metal layer on said substrate prior to the step of bias-sputtering.

3. A method as claimed in claim 2 characterized in that said metal layer comprises a refractory metal element.

4. A method as claimed in claim 3 characterized in that said refractory metal element is selected from a group comprising titanium, tungsten, molybdenum, tantalum and niobium.

5. A method as claimed in claim 1 characterized in that said characteristic temperature is chosen equal to or higher than about 400° C.

6. A method as claimed in claim 5 characterized in that said inert gas comprises argon and said material layer (34) contains aluminium.

7. A method as claimed in claim 1, 5 or 6 characterized in that said material layer (34) comprises an aluminium alloy.

8. A method as claimed in claim 1 in which said material layer (36) contains an element of refractory metals selected from a group of titanium, tungsten molybdenum and copper, and said negative characteristic bias voltage is set equal to or lower than about -1000 volts.

9. A method of manufacturing a semiconductor device comprising a step of depositing a material layer (34, 36) on a stepped surface of a substrate (31, 32) by a bias-sputtering performed in an inert gas, said bias-sputtering comprising a step of heating the substrate to a predetermined temperature and at the same time applying a predetermined negative bias voltage to the substrate during the sputtering, characterized in that said predetermined temperature and said predetermined negative bias voltage are chosen respectively so as to fall in a region (100) located above a characteristic temperature and below a negative characteristic voltage both defined in a temperature-versus-voltage field, said characteristic temperature is characterized by a decrease in the slope of a curve representing a relation between a content of the inert gas in the deposited material layer and a temperature of sputtering such that an average slope of the curve for a temperature interval of less than 100° C decreases stepwise by a factor of at least two with an increasing temperature of the sputtering across the characteristic temperature, said characteristic voltage is characterized by an increase in a rate of step coverage $\underline{R}$ defined as

$R = b/a$

where b stands for a minimum thickness of the deposited material layer on a stepped part of the substrate and a stands for a thickness of the deposited material layer on a flat part of the substrate, such that the parameter R increases at least two times with the increasing magnitude of the negative bias voltage across the characteristic voltage.

10. A method of manufacturing a semiconductor device comprising a step of depositing a material layer (34, 36) on a stepped surface of a substrate (31, 32) by a bias-sputtering performed in an inert gas, said bias-sputtering comprising a step of heating the substrate to a predetermined temperature and at the same time applying a predetermined negative bias voltage to the substrate during the sputtering, characterized in that said predetermined temperature and said predetermined negative bias voltage are chosen respectively so as to fall in a region (100) located above a characteristic temperature and below a negative characteristic voltage both defined in a temperature-versus-voltage field, said characteristic temperature characterizes said region such that a content of the inert gas in the deposited material layer is less than about 10 % of the content when the material layer is deposited at the substrate temperature set at 200° C under a negative bias voltage of which magnitude is set equal to or larger than that of the negative characteristic voltage, said negative characteristic voltage characterizes the region such that a rate of step coverage $\underline{R}$ defined as

$R = b/a$ where b stands for a minimum thickness of the deposited material layer on a stepped part of the substrate and a stands for a thickness of the deposited material layer on a flat part of the substrate, assumes a value of at least 50 % in said region.

11. A method of manufacturing a semiconductor device comprising a step of depositing a material layer (34, 36) on a stepped surface of a substrate (31, 32) by a bias-sputtering performed in an inert gas, said bias-sputtering comprising a step of heating the substrate to a predetermined temperature and at the same time applying a predetermined negative bias voltage to the substrate during the sputtering, characterized in that said predetermined temperature and said predetermined negative bias voltage are chosen respectively so as to fall in a region (100) located above a characteristic temperature and below a negative characteristic voltage both defined in a temperature-versus-voltage field, said characteristic temperature is characterized by a decrease in a content of the inert gas in the deposited material layer to below about 0.1 atomic percent above said characteristic temperature, said negative characteristic voltage is characterized by an increase in a rate of step coverage $\underline{R}$ defined as

$R = b/a$

where $\underline{b}$ stands for a minimum thickness of the deposited material layer on a stepped part of the substrate and $\underline{a}$ stands for a thickness of the deposited material layer on a flat part of the substrate, such that the parameter $\underline{R}$ assumes a value of at least 50 % in said region.

12. A method as claimed in claim 11 characterized in that said region (100) is further characterized by a median grain size of the material layer equal to or exceeding about 10,000 Å.

TCS/HL 39779

FIG. 1

FIG. 2

FIG. 3 (A)

FIG. 3(B)

FIG. 4

FIG. 5

34

32

31

33

a

b

$R = \dfrac{b}{a}$

## FIG. 6

34'

32

31

33

a

b

$R = \dfrac{b}{a}$

## FIG. 7 (PRIOR ART)

FIG. 8

R = $\frac{b}{a}$     b = min. thickness

(A) BIAS = −600 V

REGION I

REGION II

(B) T = 500 °C

REGION A

REGION B

FIG. 9

FIG. 10

FIG. 11